# EUROPEAN PATENT APPLICATION

(11) **EP 2 940 806 A1**
(43) Date of publication of application: **04.11.2015**
(21) Application number: 13867126.8
(22) Date of filing: 11.12.2013
(51) Int. Cl.: H01R 24/42, H01R 13/03

(54) **ELECTRICAL CONNECTOR**

(30) Priority: 26.12.2012 JP 2012282028
(71) Applicant: Yokowo Co., Ltd, Tokyo 114-8515 (JP)
(72) Inventor: YODOGAWA, Akihiro, Tokyo 114-8515 (JP)
(74) Representative: Strehl Schübel-Hopf & Partner
(86) International application number: PCT/JP2013/083176
(87) International publication number: WO 2014/103718

(57) **Abstract**

An electrical connector is provided that makes it possible to obtain a characteristic impedance necessary for high-speed transmission.

A first plating film 6 and a second plating film 7 are formed on an outer surface of an insulating shaft 8. A terminal section 6a of the first plating film 6 encircles the outer surface of the shaft 8 near the tip thereof. A first signal terminal 3 of a circular conductor ring is forced onto the shaft 8 from the tip thereof and contacts the terminal section 6a of the first plating film 6. A terminal section 7a of a second plating film 7 encircles the outer surface of the shaft 8 leaving a gap therebetween at a point that is closer to the base end than the terminal section 6a of the first plating film 6. A second signal terminal 4 is forced onto the shaft 8 from the tip thereof and contacts the terminal section 7a of the second plating film 7. Connection parts 6c, 7c are provided near the base end portion of the shaft 8 and are electrically connected to the cables by soldering or the like. Joining part 6b, 7b extend from the terminal section 6a, 7a to the connection part 6c, 7c to mutually electrically connect the terminal section 6a, 7a and the connection part 6c, 7c respectively.

## Description

### TECHNICAL FIELD

The present invention relates to an electrical connector for plugging (inserting) in a connection port such as an earphone jack or the like.

### BACKGROUND ART

Recently, smartphones are increasingly widely used and are required to have not only multiple functions but also designability. On the other hand, smartphones need various external connection ports such as an insertion hole for a memory card, a USB connection port, and an earphone jack or the like, which impede the pursuit of designability. Therefore, for example, by expanding the function of the earphone jack to enable transmission of digital signals, the number of the external connection ports can be reduced. To transmit digital signals, a connector must be multipolarized as compared to when only analog signals are transmitted. To achieve multipolarization of a plug, the following Patent Document 1 discloses a method in which a plurality of connection terminal pieces are formed by press formiong of a metal plate and assembled by resin molding into a coaxial multipole plug.

### PRIOR ART DOCUMENT

### Patent Document

Patent Document 1: Japanese Laid-Open Patent Publication No. 2000-340309

### SUMMARY OF THE INVENTION

### Problem to be solved by the Invention

Impedance matching is required for high-speed transmission of digital signals and a constant characteristic impedance (e.g., 50 Ω) must be given to a portion making up a transmission line of a connector. Although multipolarization can be achieved by the technique of Patent Document 1, the usage of a metal plate limits the reduction in width and thickness, causing a problem of the inability to obtain the characteristic impedance required for the high-speed transmission of digital signals.

The present invention was conceived in view of the situations and it is therefore an object of the present invention to provide an electrical connector making it possible to obtain a characteristic impedance necessary for high-speed transmission.

### Means for Solving Problem

An aspect of the present invention is an electrical connector for plugging in a connection port. The electrical connector comprises: an insulating shaft; and at least one plating film disposed on the shaft to form a conduction path.

The plating film may include a terminal section located closer to a tip, a connection part located closer to a base end, and a joining part joining the terminal section to the connection part.

The shaft may be hollow, the terminal section may be on an outer surface of the shaft, and the at least one joining part passes on an inner surface of the shaft.

The shaft may include a through-hole penetrating from the outer surface to the inner surface of the shaft, and the joining part may extend from the terminal section through an internal surface of the through-hole to the inner surface of the shaft.

The electrical connector may comprise the at least two plating films, wherein the terminal sections of the plating films are at positions different from each other in an axial direction of the shaft, the terminal section closer to the base end is not formed on a part of circling position of the outer surface of the shaft in a direction around an axis of the shaft, and the joining part extending from the terminal section closer to the tip passes through the part of the position on the outer surface of the shaft to reach the connection part.

The electrical connector may comprise the at least two plating films, wherein the terminal sections of the plating films are at positions different from each other in the axial direction of the shaft, and the joining part extending from the terminal section closer to the tip passes through the inside of the terminal section closer to the base end to reach the connection part.

The terminal section may form a contact part for a counterpart terminal.

The electrical connector may comprise a conductor ring attached to the shaft to come into contact with the terminal section.

The electrical connector may comprise the at least two plating films and at least two conductor rings attached to the shaft to come into contact with the respective terminal sections of the plating films, wherein the terminal sections of the plating films are at positions different from each other in the axial direction of the shaft, an outer diameter of the shaft at the position of the terminal section closer to the base end is larger than an outer diameter of the shaft at the position of the terminal section closer to the tip, and an inner diameter of the conductor ring coming into contact with the terminal section closer to the base end is larger than an inner diameter of the conductor ring coming into contact with the terminal section closer to the tip.

The outer surface of the shaft may be disposed with a step for positioning the conductor ring.

The electrical connector may comprise the at least two plating films, wherein the connection parts of the two plating films are at positions different from each other in the axial direction of the shaft and at the positions around the axis of the shaft at least partially overlapped with each other.

The electrical connector may have a multipolarized structure, and the plating films at least form respective conduction paths for signal transmission.

It is to be noted that any arbitrary combination of the above-described structural components as well as the expressions according to the present invention changed among a system and so forth are all effective as and encompassed by the present aspects.

### Effect of the Invention

The present invention can provide the electrical connector making it possible to obtain a characteristic impedance necessary for high-speed transmission.

### BRIEF DESCRIPTION OF DRAWINGS

Fig. 1 is a partially cross-sectional perspective view of an electrical connector before molding according to a first embodiment of the present invention.
Fig. 2 is a perspective view of the electrical connector depicted in Fig. 1 after molding.
Fig. 3 is an exploded perspective view of the electrical connector depicted in Fig. 1.
Fig. 4 is a perspective view of a conduction path forming body 16 of the electrical connector depicted in Fig. 1.
Fig. 5 is a perspective view of only a first plating film 6 and a second plating film 7 extracted from the conduction path forming body 16 depicted in Fig. 4.
Fig. 6 is a plane view of the conduction path forming body 16 depicted in Fig. 4.
Fig. 7 is a bottom view of the same.
Fig. 8 is a perspective view of a conduction path forming body 16 of an electrical connector according to a second embodiment of the present invention.
Fig. 9 is a perspective view of only a first plating film 6 and a second plating film 7 extracted from the conduction path forming body 16 depicted in Fig. 8.
Fig. 10 is a perspective view of the second plating film 7 depicted in Fig. 9.
Fig. 11 is a perspective view of the first plating film 6 depicted in Fig. 9.
Fig. 12 is a perspective view of an electrical connector according to a third embodiment of the present invention.
Fig. 13 is a first perspective view of a conduction path forming body 16 of the electrical connector depicted in Fig. 12.
Fig. 14 is a perspective view of only a first plating film 21 to an eighth plating film 28 extracted from the conduction path forming body 16 depicted in Fig. 13.
Fig. 15 is a second perspective view of the conduction path forming body 16 depicted in Fig. 13.
Fig. 16 is a third perspective view of the same.
Fig. 17 is a perspective cross-sectional view of one side of the conduction path forming body 16 depicted in Fig. 13 cut in half.
Fig. 18 is a perspective cross-sectional view of the other side of the same.
Fig. 19 is a perspective view of each of the first to eighth plating films 21 to 28 depicted in Fig. 14.

### EMBODIMENT FOR CARRYING OUT THE INVENTION

The invention will now be described based on the following embodiments which do not intend to limit the scope of the present invention but exemplify the invention. All of the features and the combinations thereof described in the embodiments are not necessarily essential to the invention.

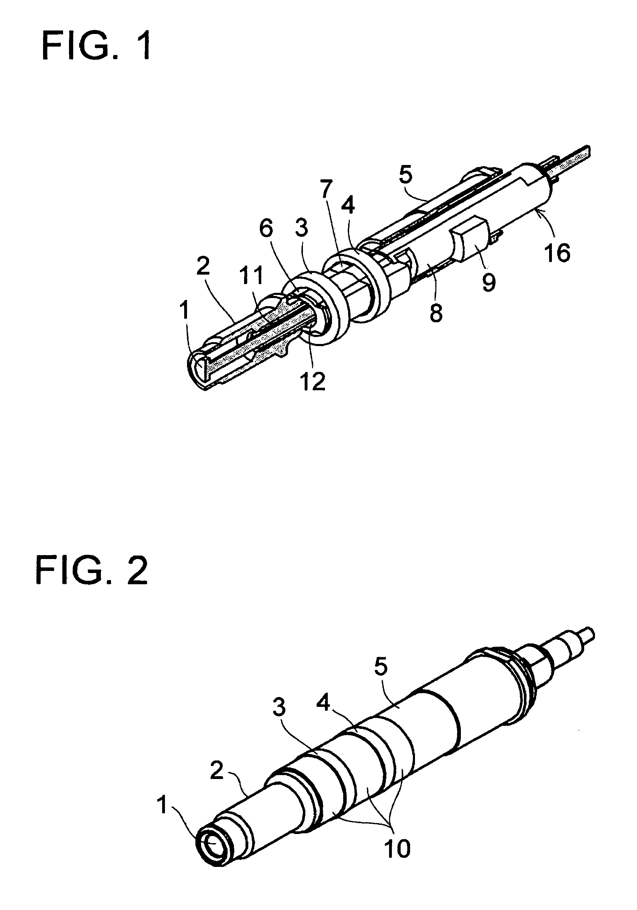

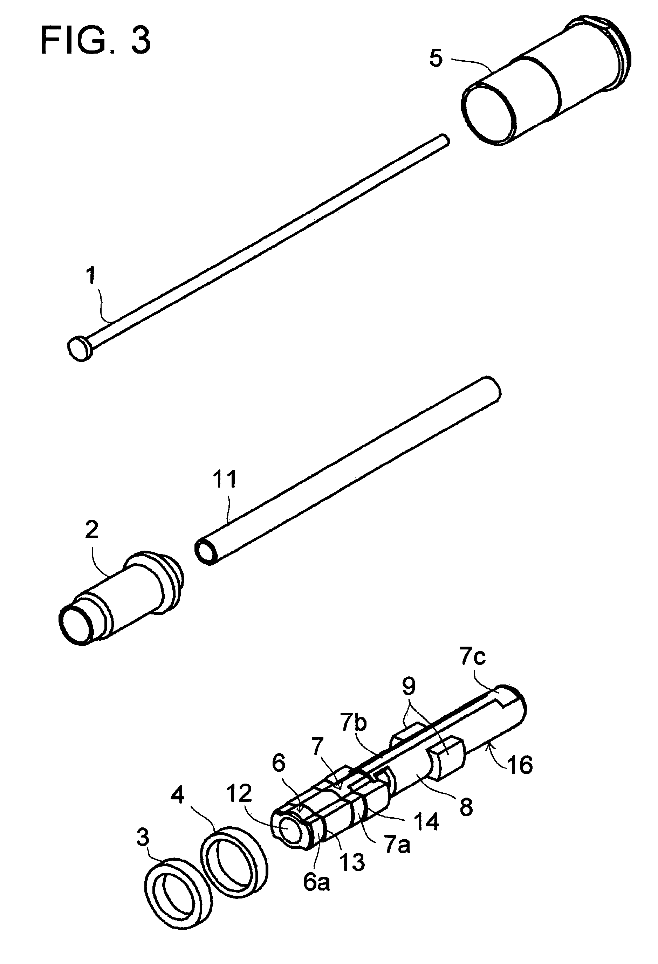

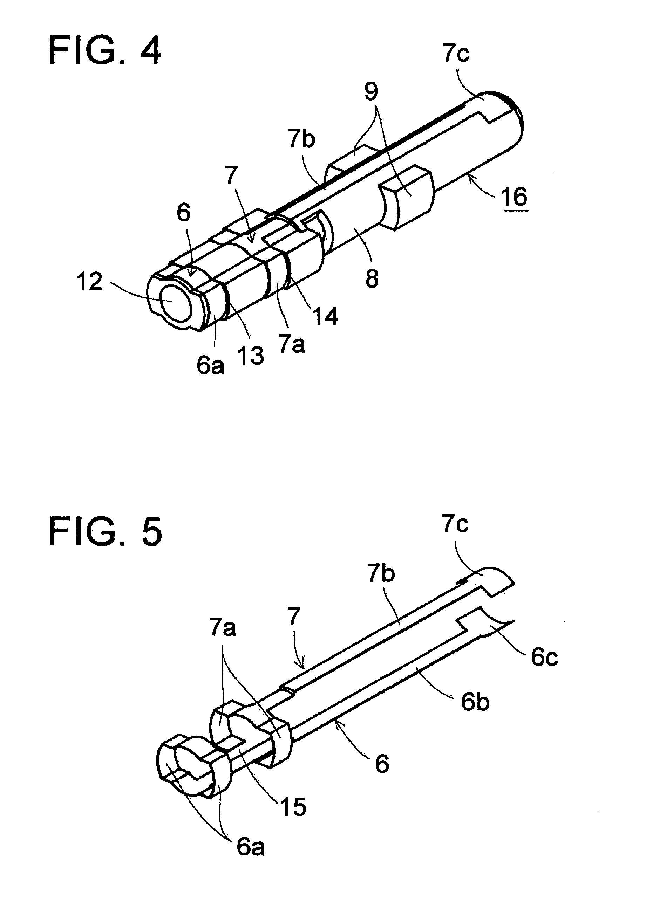

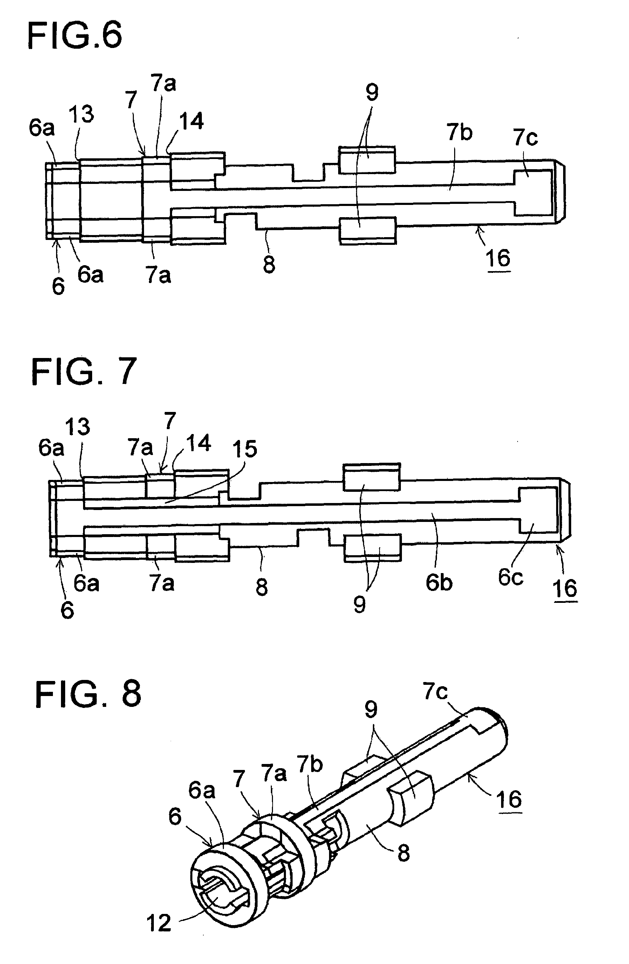

Fig. 1 is a partially cross-sectional perspective view of an electrical connector before molding according to a first embodiment of the present invention. Fig. 2 is a perspective view of the electrical connector depicted in Fig. 1 after molding. Fig. 3 is an exploded perspective view of the electrical connector depicted in Fig. 1. Fig. 4 is a perspective view of a conduction path forming body 16 of the electrical connector depicted in Fig. 1. Fig. 5 is a perspective view of only a first plating film 6 and a second plating film 7 extracted from the conduction path forming body 16. Fig. 6 is a plane view of the conduction path forming body 16. Fig. 7 is a bottom view of the conduction path forming body 16.

The electrical connector of this embodiment is a plug of a five-pole configuration disposed at a tip of a cable not depicted and inserted into a connection port (jack) such as an earphone jack etc. and includes a power terminal 1, a power ground terminal 2, a first signal terminal 3, a second signal terminal 4, and a ground terminal 5.

The power terminal 1 is a rod-shaped conductor (e.g., a metal body) and has a tip portion to be in contact with a terminal of an insertion destination jack and a base end portion electrically connected to cables not depicted by soldering or the like. The power ground terminal 2 is a pipe-shaped conductor (e.g., a metal body) and has a tip portion to be in contact with a terminal of the insertion destination jack. A pipe-shaped conductive joint 11 (e.g., a metal body) is connected (fit) to the base end side of the power ground terminal 2, so that the power ground terminal 2 is electrically extended to the base end side (toward the cables). Abase end side of the joint 11 is electrically connected to the cables not depicted by soldering or the like. The first signal terminal 3 is, for example, a circular conductor ring (e.g., a metal body). The first signal terminal 3 has an outer circumferential surface to be in contact with a terminal of the insertion destination jack and an inner circumferential surface in contact with a first plating film 6 described later. The second signal terminal 4 is, for example, a circular conductor ring (e.g., a metal body). The second signal terminal 4 has an outer circumferential surface to be in contact with a terminal of the insertion destination jack and an inner circumferential surface in contact with a second plating film 7 described later. The outer diameter of the first signal terminal 3 is the same as the outer diameter of the second signal terminal 4 and the inner diameter of the first signal terminal 3 is smaller than the inner diameter of the second signal terminal 4. The first signal terminal 3 and the second signal terminal 4 make a pair of positive and negative terminals for differential transmission of signals. The ground terminal 5 is a pipe-shaped metal body and has a tip portion to be in contact with a terminal of the insertion destination jack and a base end portion electrically connected to the cables not depicted by soldering or the like.

The first plating film 6 and the second plating film 7 are formed on an outer surface of an insulating shaft 8. The shaft 8 is, for example, a resin molded body and has a pair of convex portions 9 on the outer surface and a through-hole 12 in an axially-viewed center portion. The convex portions 9 are for positioning the ground terminal 5 in the axially perpendicular direction. The through-hole 12 is for insertion of the joint 11. The first plating film 6, the second plating film 7, and the shaft 8 form a conduction path forming body 16. The electrical connector depicted in Fig. 2 is completed by molding (injection-molding) with resin 10 while the terminals and the conduction path forming body 16 are combined as depicted in Fig. 1.

The first plating film 6 and the second plating film 7 are formed by nickel plating on foundation copper plating, for example. Specifically, after electroless copper plating is first formed on the entire surface of the shaft 8, the portions corresponding to the first plating film 6 and the second plating film 7 are covered with a resist (protective film). The copper plating is removed except in the covered portions by the resist and the electroless nickel plating is formed on the remaining copper plating.

The first plating film 6 has a terminal section 6a, a joining part 6b, and a connection part 6c. The terminal section 6a encircles the outer surface of the shaft 8 near the tip thereof. A portion of the terminal section 6a is in contact with the first signal terminal 3. In particular, the first signal terminal 3 is forced onto the shaft 8 from the tip thereof and contacts the portion of the terminal section 6a of the first plating film 6. The connection part 6c is provided near the base end of the shaft 8 and is electrically connected to the cables not depicted by soldering or the like. The joining part 6b extends from the terminal section 6a to the connection part 6c to mutually join (mutually electrically connect) the terminal section 6a and the connection part 6c.

The second plating film 7 has a terminal section 7a, a joining part 7b, and a connection part 7c. The terminal section 7a encircles the outer surface of the shaft 8 leaving a gap 15 therebetween at a point that is closer to the base end than the terminal section 6a of the first plating film 6. In particular, the terminal section 7a is not formed at the position (gap 15) that is a portion on the outer surface of the shaft 8 around the axis thereof. A portion of the terminal section 7a is in contact with the second signal terminal 4. In particular, the second signal terminal 4 is forced onto the shaft 8 from the tip thereof and contacts a portion of the terminal section 7a of the second plating film 7. The connection part 7c is provided near the base end of the shaft 8 and is electrically connected to the cables not depicted by soldering or the like. The joining part 7b extends from the terminal section 7a to the connection part 7c to mutually join (mutually electrically connect) the terminal section 7a and the connection part 7c.

The shaft 8 has a cross-sectional external shape that is not circular on the tip side (at the formation positions of the terminal sections 6a, 7a), and the shaft 8 and the second signal terminal 4 are not in contact with each other at the position of the gap 15 of the terminal section 7a of the second plating film 7. Therefore, the joining part 6b of the first plating film 6 can pass through the gap 15 as depicted in Figs. 5 and 7 to reach the connection part 6c from the terminal section 6a without contact with the second signal terminal 4 and the second plating film 7.

The shaft 8 has respective steps 13, 14 on the base end side of the formation positions of the terminal sections 6a, 7a. The both steps 13, 14 have a shape raised on the base end side as compared to the tip side (having a larger diameter on the base end side as compared to the tip side). The step 13 is for positioning the first signal terminal 3. The step 14 is for positioning the second signal terminal 4. When the second signal terminal 4 is forced onto the shaft 8 from the tip, the step 14 locks the second signal terminal 4 at the position where the second signal terminal 4 comes into contact with the terminal section 7a of the second plating film 7. When the first signal terminal 3 is forced onto the shaft 8 from the tip, the step 13 locks the first signal terminal 3 at the position where the first signal terminal 3 comes into contact with the terminal section 6a of the first plating film 6. The steps 13, 14 facilitate the press fitting of the first signal terminal 3 and the second signal terminal 4 to the shaft 8.

According to this embodiment, since the first plating film 6 and the second plating film 7 form a conduction path for signals, the width and thickness of the conduction path can be made smaller as compared to the conventional case that a metal plate forms a conduction path for signals, and a characteristic impedance required for high-speed transmission of digital signals (characteristic impedance for a transmission line) can be obtained to match the impedance. This enables the transmission of digital signals in addition to the transmission of analog signals (stereo signals), which contributes to reduction of external connection terminals in a portable device such as a smartphone. Additionally, the conduction path can be made thinner, which is advantageous for multipolarization of the electrical connector.

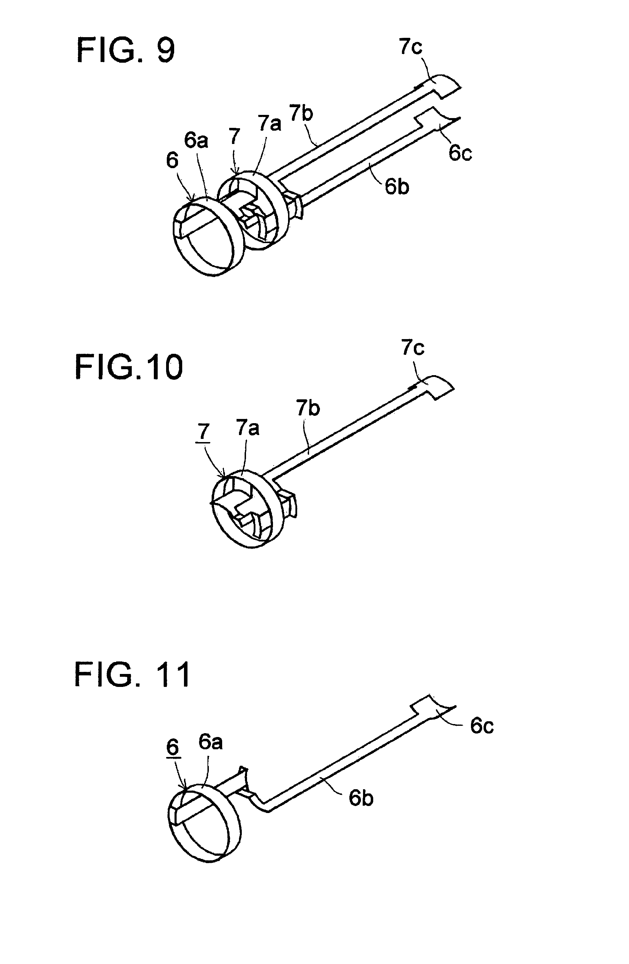

Fig. 8 is a perspective view of the conduction path forming body 16 of the electrical connector according to a second embodiment of the present invention. Fig. 9 is a perspective view of only the first plating film 6 and the second plating film 7 extracted from the conduction path forming body 16 depicted in Fig. 8. Fig. 10 is a perspective view of the second plating film 7 depicted in Fig. 9. Fig. 11 is a perspective view of the first plating film 6 depicted in Fig. 9. The electrical connector of this embodiment is different from the first embodiment in that the conductive rings are not used for the first signal terminal 3 and the second signal terminal 4 while the both terminal sections 6a, 7a of the first plating film 6 and the second plating film 7 have a ring shape (an annular shape) closed around the axis to form the first signal terminal 3 and the second signal terminal 4, respectively (contact parts for counterpart terminals). The shaft 8 has a circular cross-sectional external shape at the formation positions of the terminal sections 6a, 7a. The joining part 6b of the first plating film 6 can pass on the internal surface of the through-hole 12 of the shaft 8 to go through the inside of the terminal section 7a of the second plating film 7 without contact with the terminal section 7a and reach the connection part 6c. This embodiment is the same as the first embodiment except this point. This embodiment can provide the same effects as the first embodiment and, since the joining part 6b of the first plating film 6 passes on the internal surface of the through-hole 12 of the shaft 8 to go through the connection part 7c of the second plating film 7 located closer to the base end, the connection part 7c can be formed into a ring shape closed around the axis and the connection part can be used as the contact portion for the counterpart terminal without using a conductor ring as in the first embodiment.

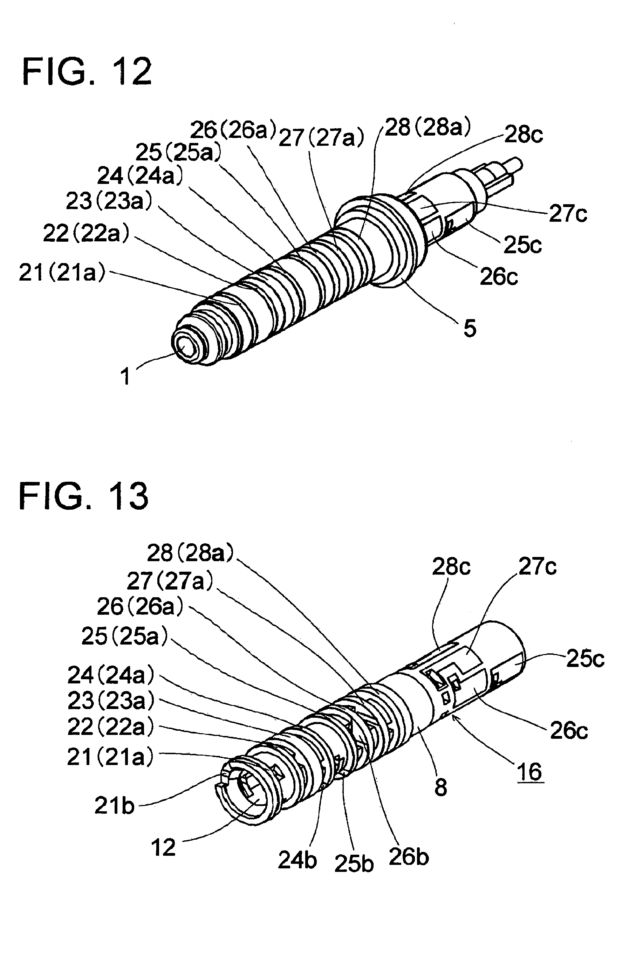

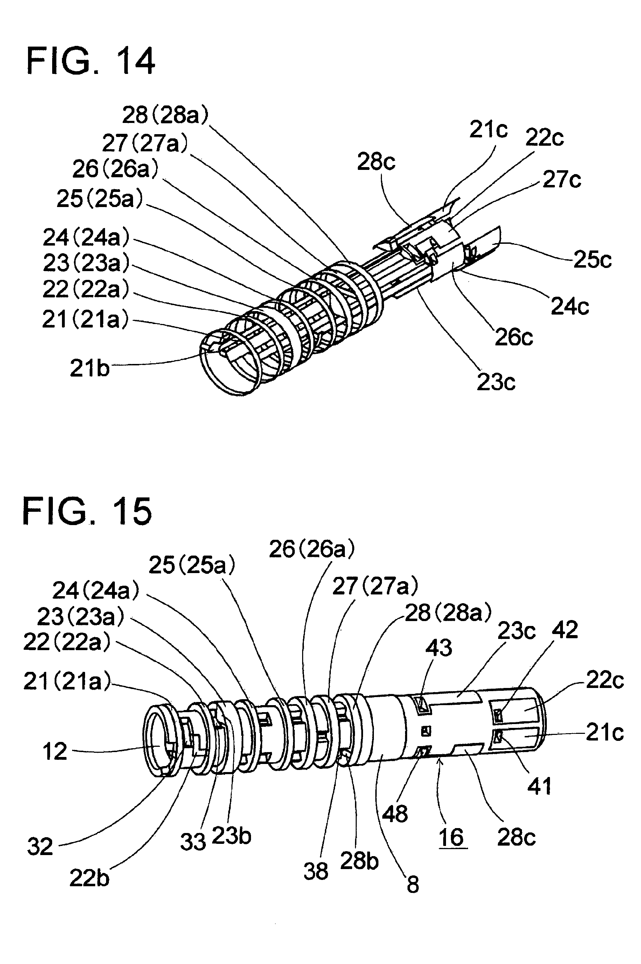

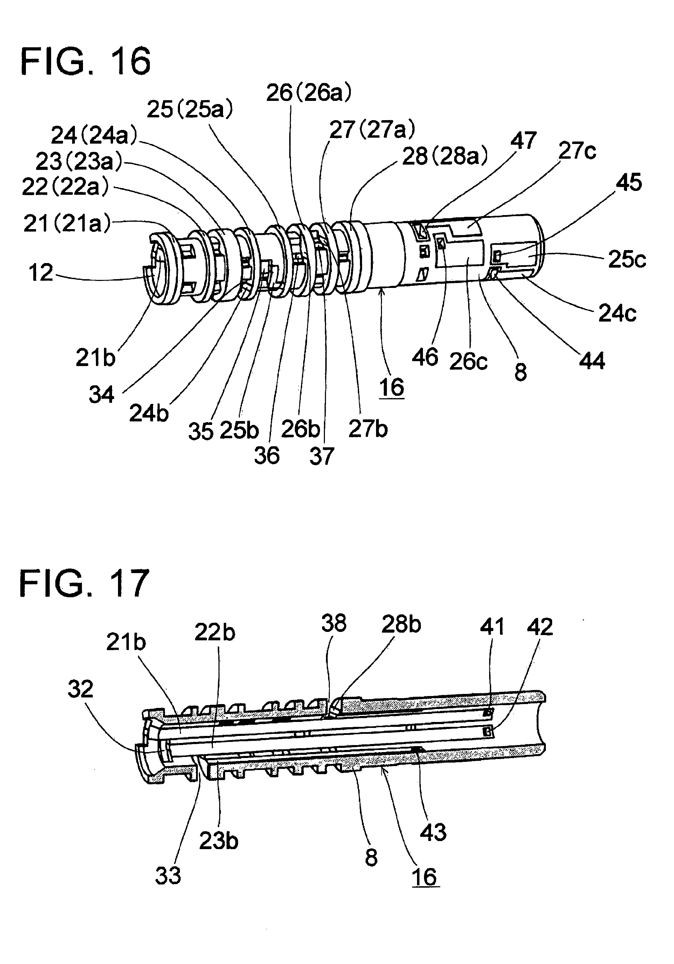

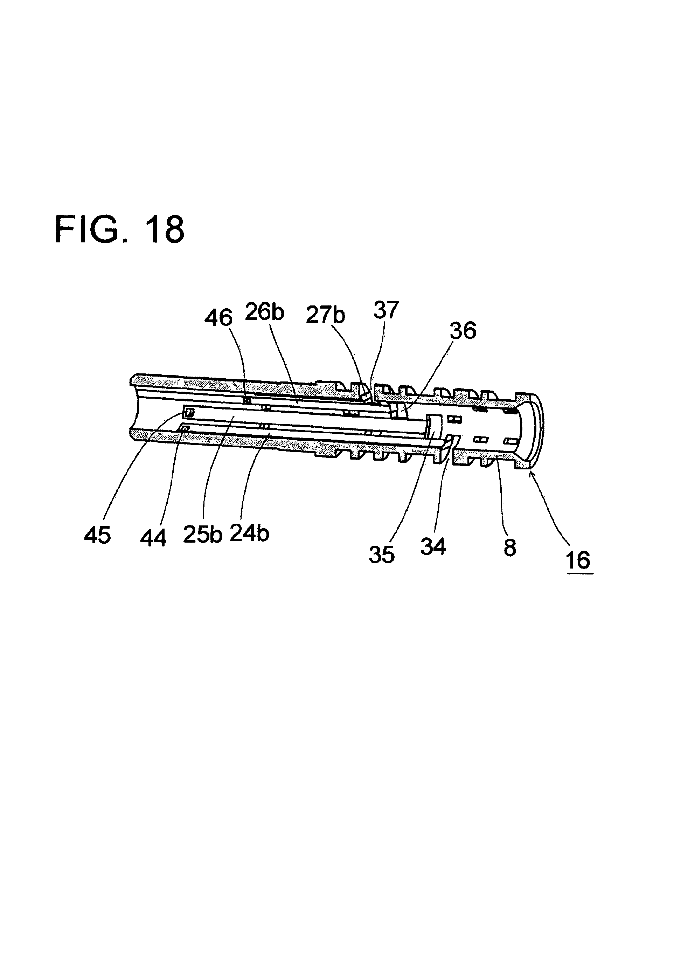

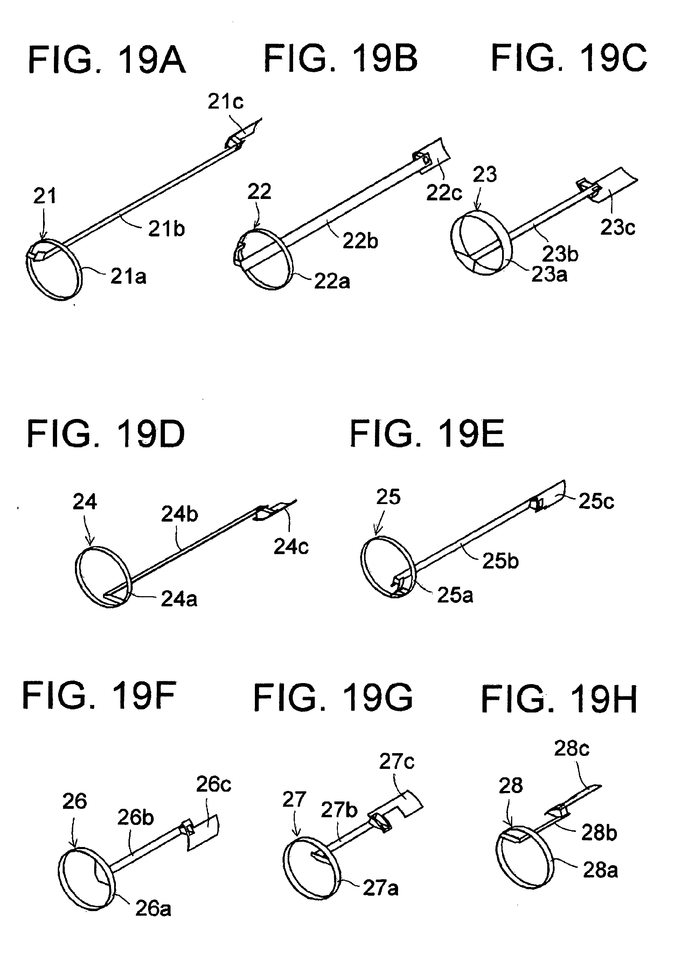

Fig. 12 is a perspective view of the electrical connector according to a third embodiment of the present invention. Fig. 13 is a first perspective view of the conduction path forming body 16 of the electrical connector depicted in Fig. 12. Fig. 14 is a perspective view of only a first plating film 21 to an eighth plating film 28 extracted from the conduction path forming body 16 depicted in Fig. 13. Fig. 15 is a second perspective view of the conduction path forming body 16 depicted in Fig. 13. Fig. 16 is a third perspective view of the same. Fig. 17 is a perspective cross-sectional view of one side of the conduction path forming body 16 depicted in Fig. 13 cut in half. Fig. 18 is a perspective cross-sectional view of the other side of the same. Figs. 19A to 19H are respective perspective views of the first to eighth plating films 21 to 28 depicted in Fig. 14.

The electrical connector of this embodiment depicted in Fig. 12 is a plug having plating films for eight poles in addition to the two poles of the power terminal 1 and the ground terminal 5, i.e., having 10 poles in total. The electrical connector depicted in Fig. 12 is completed by molding (injection molding) with resin 10 while the power terminal 1 and the ground terminal 5 are combined with the conduction path forming body 16 as depicted in Fig. 13.

Terminal sections 21a, 22a of the first plating film 21 and the second plating film 22 make a first pair of positive and negative terminals for differential transmission of signals. Terminal sections 24a, 25a of the fourth plating film 24 and the fifth plating film 25 make a second pair of positive and negative terminals for differential transmission of signals. A terminal section 23a of the third plating film 23 is a signal ground (SG) terminal of the first and second pairs. A terminal section 26a of the sixth plating film 26 is an ID terminal for identification of a connected device. Terminal sections 27a, 28a of the seventh plating film 27 and the eighth plating film 28 make a third pair of positive and negative terminals for differential transmission of signals. The terminal sections 21a to 28a are each formed into a closed ring shape (annular shape) and are sequentially arranged in line on the outer surface of the shaft 8 from the tip toward the base end at predetermined intervals.

The shaft 8 is provided with through-holes 32 to 38 and through-holes 41 to 48 penetrating from the outer surface to the inner surface. The through-holes 32 to 38 are opened near the terminal sections 22a to 28a of the second plating film 22 to the eighth plating film 28. The through-holes 41 to 48 are opened at the formation positions of connection parts 21c to 28c of the first plating film 21 to the eighth plating film 28.

A joining part 21b of the first plating film 21 extends from the terminal section 21a, extends through the tip of the shaft 8 from the outer surface to the inner surface of the shaft 8, reaches the through-hole 41 through the inner surface of the shaft 8, and further reaches the connection part 21c on the outer surface through the internal surface of the through-hole 41. A joining part 22b of the second plating film 22 extends from the terminal section 22a, extends through the internal surface of the through-hole 32 from the outer surface to the inner surface of the shaft 8, reaches the through-hole 42 through the inner surface of the shaft 8, and further reaches the connection part 22c on the outer surface through the internal surface of the through-hole 42. A joining part 23b of the third plating film 23 extends from the terminal section 23a, extends through the internal surface of the through-hole 33 from the outer surface to the inner surface of the shaft 8, reaches the through-hole 43 through the inner surface of the shaft 8, and further reaches the connection part 23c on the outer surface through the internal surface of the through-hole 43. A joining part 24b of the fourth plating film 24 extends from the terminal section 24a, extends through the internal surface of the through-hole 34 from the outer surface to the inner surface of the shaft 8, reaches the through-hole 44 through the inner surface of the shaft 8, and further reaches the connection part 24c on the outer surface through the internal surface of the through-hole 44. A joining part 25b of the fifth plating film 25 extends from the terminal section 25a, extends through the internal surface of the through-hole 35 from the outer surface to the inner surface of the shaft 8, reaches the through-hole 45 through the inner surface of the shaft 8, and further reaches the connection part 25c on the outer surface through the internal surface of the through-hole 45. A joining part 26b of the sixth plating film 26 extends from the terminal section 26a, extends through the internal surface of the through-hole 36 from the outer surface to the inner surface of the shaft 8, reaches the through-hole 46 through the inner surface of the shaft 8, and further reaches the connection part 26c on the outer surface through the internal surface of the through-hole 46. A joining part 27b of the seventh plating film 27 extends from the terminal section 27a, extends through the internal surface of the through-hole 37 from the outer surface to the inner surface of the shaft 8, reaches the through-hole 47 through the inner surface of the shaft 8, and further reaches the connection part 27c on the outer surface through the internal surface of the through-hole 47. A joining part 28b of the eighth plating film 28 extends from the terminal section 28a, extends through the internal surface of the through-hole 38 from the outer surface to the inner surface of the shaft 8, reaches the through-hole 48 through the inner surface of the shaft 8, and further reaches the connection part 28c on the outer surface through the internal surface of the through-hole 48. As depicted in Figs. 17 and 18, the joining parts 21b to 28b are formed on the inner surface of the shaft 8 around the axis at predetermined intervals from each other so as not to come into contact with the adjacent joining parts.

The connection parts 21c, 22c of the first plating film 21 and the second plating film 22 making a pair are formed to have substantially the same length with each other. Similarly, the connection parts 24c, 25c of the fourth plating film 24 and the fifth plating film 25 making a pair are formed to have substantially the same length with each other. Similarly, the connection parts 27c, 28c of the seventh plating film 27 and the eighth plating film 28 making a pair are formed to have substantially the same length with each other.

The connection parts 21c, 22c of the first plating film 21 and the second plating film 22 making a pair are arranged closely to each other on the outer surface of the shaft 8. Similarly, the connection parts 24c, 25c of the fourth plating film 24 and the fifth plating film 25 making a pair are arranged closely to each other on the outer surface of the shaft 8. Similarly, the connection parts 27c, 28c of the seventh plating film 27 and the eighth plating film 28 making a pair are arranged closely to each other on the outer surface of the shaft 8.

To arrange the connection parts 21c to 28c in a limited space on the outer surface of the shaft 8, the connection parts 21c, 22c, 24c, 25c and the connection parts 23c, 26c, 27c, 28c are located at positions different from each other in the axial direction of the shaft 8, and some of the connection parts, for example, the connection parts 21c, 28c and the connection parts 25c, 26c are located at the positions around the axis of the shaft 8 at least partially overlapped with each other.

This embodiment can provide the same effects as the first and second embodiments. Additionally, this embodiment enables high-speed signal transmission by taking advantage of the plating films, which can narrowly be formed. Moreover, since the joining parts 21b to 28b are formed on the inner surface of the shaft 8 around the axis at predetermined intervals from each other, many plating films can be formed on the shaft to achieve multipolarization as compared to the conventional technique.

Described above is an explanation based on the embodiment. The description of the embodiments is illustrative in nature and various variations in constituting elements and processes involved are possible. Those skilled in the art would readily appreciate that such variations are also within the scope of the present invention.

### EXPLANATIONS OF LETTERS OR NUMERALS

1 Power terminal, 2 Power ground terminal, 3 First signal terminal, 4 Second signal terminal, 5 Ground terminal, 6 First plating film, 6a Terminal section, 6b joining part, 6c connection part, 7 Second plating film, 7a Terminal section, 7b joining part, 7c connection part, 8 shaft, 9 convex portion, 10 Resin, 11 Joint, 12 Through hole, 13 Step, 14 Step, 15 Gap, 16 Conduction path forming body, 21 First plating film, 21a Terminal section, 21b joining part, 21c connection part, 22 Second plating film, 22a Terminal section, 22b joining part, 22c connection part, 23 Third plating film, 23a Terminal section, 23b joining part, 23c connection part, 24 Fourth plating film, 24a Terminal section, 24b joining part, 24c connection part, 25 Fifth plating film, 25a Terminal section, 25b joining part, 25c connection part, 26 Sixth plating film, 26a Terminal section, 26b joining part, 26c connection part, 27 Seventh plating film, 27a Terminal section, 27b joining part, 27c connection part, 28 Eighth plating film, 28a Terminal section, 28b joining part, 28c connection part, 32-38 Through hole, 41-48 Through hole

## Claims

1. An electrical connector for plugging in a connection port, comprising:
an insulating shaft; and at least one plating film disposed on the shaft to form a conduction path.

2. The electrical connector according to claim 1, wherein the plating film includes a terminal section located closer to a tip, a connection part located closer to a base end, and a joining part joining the terminal section to the connection part.

3. The electrical connector according to claim 2, wherein the shaft is hollow, the terminal section is on an outer surface of the shaft, and the at least one joining part passes on an inner surface of the shaft.

4. The electrical connector according to claim 3, wherein the shaft includes a through-hole penetrating from the outer surface to the inner surface of the shaft, and the joining part extends from the terminal section through an internal surface of the through-hole to the inner surface of the shaft.

5. The electrical connector according to claim 2, comprising the at least two plating films, wherein the terminal sections of the plating films are at positions different from each other in an axial direction of the shaft, the terminal section closer to the base end is not formed on a part of circling position of the outer surface of the shaft in a direction around an axis of the shaft, and the joining part extending from the terminal section closer to the tip passes through the part of the position on the outer surface of the shaft to reach the connection part.

6. The electrical connector according to claim 2, comprising the at least two plating films, wherein the terminal sections of the plating films are at positions different from each other in the axial direction of the shaft, and the joining part extending from the terminal section closer to the tip passes through the inside of the terminal section closer to the base end to reach the connection part.

7. The electrical connector according to any one of claims 2 to 6, wherein the terminal section forms a contact part for a counterpart terminal.

8. The electrical connector according to any one of claims 2 to 6, comprising a conductor ring attached to the shaft to come into contact with the terminal section.

9. The electrical connector according to any one of claims 2 to 6, comprising the at least two plating films and at least two conductor rings attached to the shaft to come into contact with the respective terminal sections of the plating films, wherein the terminal sections of the plating films are at positions different from each other in the axial direction of the shaft, an outer diameter of the shaft at the position of the terminal section closer to the base end is larger than an outer diameter of the shaft at the position of the terminal section closer to the tip, and an inner diameter of the conductor ring coming into contact with the terminal section closer to the base end is larger than an inner diameter of the conductor ring coming into contact with the terminal section closer to the tip.

10. The electrical connector according to claim 8 or 9, wherein the outer surface of the shaft is disposed with a step for positioning the conductor ring.

11. The electrical connector according to any one of claims 2 to 10, comprising the at least two plating films, wherein the connection parts of the two plating films are at positions different from each other in the axial direction of the shaft and at the positions around the axis of the shaft at least partially overlapped with each other.

12. The electrical connector according to any one of claims 1 to 11, wherein the electrical connector has a multipolarized structure, and wherein the plating films at least form respective conduction paths for signal transmission.
